# FASCICULE DE BREVET EUROPEEN

(11) **EP 0 654 897 B1**
(45) Date de publication et mention de la délivrance du brevet: **13.01.1999**
(21) Numéro de dépôt: 94402576.6
(22) Date de dépôt: 15.11.1994
(51) Int. Cl.: H03G 3/00, H03G 3/20, G01S 3/04

(54) **Dispositif de commande automatique de gain dans une chaîne de réception radiofréquence**
Automatische Verstärkungsregelung in Funkempfängern
Automatic gain control device in an RF receiver

(30) Priorité: 19.11.1993 FR 9313879
(43) Date de publication de la demande: 24.05.1995
(73) Titulaire: THOMSON-CSF, 75008 Paris (FR)
(72) Inventeur: Chadeyron, Serge, F-92402 Courbevoie Cedex (FR); Delannoy, Jean, F-92402 Courbevoie Cedex (FR); Delecrin, Jean, F-92402 Courbevoie Cedex (FR)
(74) Mandataire: Lincot, Georges

(56) Documents cités:
- EP-A- 0 148 672
- US-A- 3 786 506
- US-A- 4 683 386
- PATENT ABSTRACTS OF JAPAN vol. 12, no. 303 (P-746) 18 Août 1988 & JP-A-63 075 684 (ISHII KEIYO E.A.) 6 Avril 1988
- PATENT ABSTRACTS OF JAPAN vol. 5, no. 73 (P-61) 15 Mai 1981 & JP-A-56 021 077 (MORI KEIJI E.A.) 27 Février 1981

## Description

La présente invention concerne un dispositif de commande automatique de gain dans une chaîne de réception radiofréquence.

Elle s'applique notamment à la réalisation de radiogoniomètres multivoies reliées à un même ensemble antennaire.

Dans les chaînes de réception radio, le dispositif de commande automatique de gain permet d'assurer une régulation de gain pour obtenir en sortie de la chaîne un niveau de signal acceptable indépendant du niveau du signal appliqué à son entrée (voir, par exemple, US-A-3 786 506). Le dispositif de commande automatique de gain agit classiquement directement sur le gain des amplificateurs ou sur des atténuateurs commandés en tension. Cependant comme ceux-ci agissent en permanence en fonction du niveau de signal détecté dans la bande passante du récepteur, il n'est généralement pas possible de connaître avec précision la valeur du gain à chaque instant en radiogoniométrie notamment, où il serait souhaitable de pouvoir figer le gain des récepteurs en période d'acquisition d'une émission, cette période étant plus ou moins longue selon la nature des opérations de traitement de signal à effectuer.

Le but de l'invention est de pallier les inconvénients précités.

A cet effet l'invention a pour objet, un dispositif de commande automatique de gain dans une chaîne de réception radiofréquence comportant, une tête de réception HF couplée à une chaîne de démodulation par l'intermédiaire d'un atténuateur programmable, caractérisé en ce qu'il comprend d'une part, une mémoire de valeurs d'atténuation adressée par le niveau du signal appliqué à l'entrée de la chaîne de démodulation et couplée par ses sorties de donnée aux entrées de commande de l'atténuateur programmable, et d'autre part un interrupteur interposé en série entre l'atténuateur et la chaîne de démodulation pour isoler la chaîne de démodulation de l'atténuateur lors de la programmation de l'atténuateur par la valeur d'atténuation adressée dans la mémoire.

L'invention a pour avantage, qu'elle permet pour des applications de radiogoniométrie notamment de maintenir de façon stable en période d'acquisition le gain d'amplification de chaînes radio.

En mesurant ce gain de façon précise, elle facilite en radiogoniométrie le réglage, de plusieurs récepteurs reliés à un réseau antennaire, sur le même gain pendant la période d'acquisition.

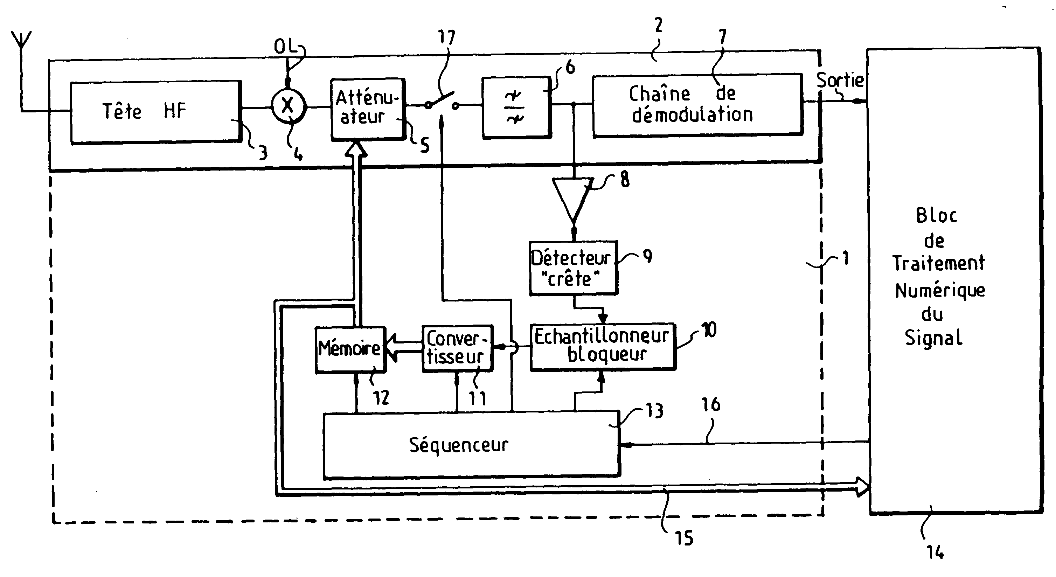

D'autres caractéristiques et avantages de l'invention apparaîtront à l'aide de la description qui suit faite en regard de la figure unique annexée qui représente un mode de réalisation d'un dispositif de commande automatique de gain selon l'invention.

Le dispositif de contrôle automatique de gain selon l'invention qui est représenté sur la figure unique à l'intérieur d'une ligne fermée en pointillés 1 est couplé à un récepteur 2 comportant de façon connue une tête HF 3, un mélangeur de fréquence 4, un atténuateur programmable 5, un filtre HF 6 et une chaîne de démodulation 7. Le dispositif 1 comporte un amplificateur logarithmique 8, un détecteur de crête 9, un échantillonneur bloqueur 10, un convertisseur numérique analogique 11 et une mémoire de valeurs d'atténuation 12 formé éventuellement par une mémoire morte programmable. Les éléments 8 à 12 sont reliés dans cet ordre en série entre la sortie du filtre 6 et une entrée de commande de l'atténuateur 5. Un bloc de traitement numérique du signal 14 est couplé d'une part, à la sortie de la chaîne de démodulation 7 et d'autre part, à un bus de données 15 couplé à la mémoire 12 et à des entrées de commande de l'atténuateur programmable 5. Le bloc 14 assure également par une ligne de commande 16 la commande du séquenceur 13. Le séquenceur 13 commande l'échantillonneur bloqueur 10, le convertisseur analogique numérique 11, les cycles de lecture de la mémoire 12 ainsi qu'un interrupteur ou relais 17 placé en série entre la sortie de l'atténuateur 5 et l'entrée du filtre 6.

Le fonctionnement est le suivant. A chaque demande de positionnement dans une bande de fréquence déterminée du récepteur 2 par le bloc de traitement 14, un mot de commande est appliqué, à un instant t₁, sur la ligne de données 16 pour commander le séquenceur 13. Au reçu de ce mot de commande le séquenceur 13 invalide le convertisseur analogique numérique 11 et commande l'interrupteur 17 pour ouvrir la liaison entre la sortie de l'atténuateur 5 et l'entrée du filtre 6. A l'instant t₁, la valeur de l'atténuation dans l'atténuateur 5 est réglée pour que le niveau du signal entre l'entrée de la tête HF et la sortie de la chaîne de démodulation 7 soit approximativement le même. A un instant suivant t₂, l'interrupteur 17 est commandé pour mettre en liaison la sortie de l'atténuateur 5 avec l'entrée du filtre 6. Pendant la durée t₂₋t₁, la valeur mémorisée dans l'échantillonneur bloqueur 10 est d'abord mise à zéro avant de mémoriser à nouveau l'amplitude crête du signal sortant du filtre 6. La valeur crête du signal mémorisée par l'échantillonneur bloqueur 10 est convertie par le convertisseur analogique numérique 11, et la valeur binaire obtenue est appliquée sur des lignes d'adresse de la mémoire 12. Comme à chaque ligne d'adresse de la mémoire 12 est mémorisée une valeur d'atténuation de l'atténuateur 5, chaque valeur binaire obtenue à la sortie du convertisseur analogique numérique 11 sélectionne une valeur d'atténuation dans la mémoire 12, et cette valeur d'atténuation est appliquée sur des entrées de commande correspondantes de l'atténuateur 5. Cependant la commande de l'atténuateur n'a lieu qu'après ouverture de l'interrupteur 17, pour qu'aucun signal ne puisse être transmis au bloc de traitement 14 durant la programmation de l'atténuateur. Lorsque la programmation de l'atténuateur 5 est terminée, l'interrupteur 17 est à nouveau fermé, et la commande du séquenceur sur la ligne 16 est supprimée, pour ne pas perturber la réception des signaux à faible niveau. A ce dernier instant la valeur d'atténuation de l'atténuateur 5 est transmise sur le bus 15 au bloc de traitement 14, qui peut ainsi utiliser cette valeur pour l'analyse et le traitement des signaux issus de récepteurs identiques en phase d'acquisition de signal dans des radiogoniomètres multivoies reliées à un même ensemble antennaire.

## Revendications

1. Dispositif de commande automatique de gain dans une chaîne de réception radiofréquence comportant, une tête de réception HF (3) couplée à une chaîne de démodulation (7) par l'intermédiaire d'un atténuateur programmable (5), caractérisé en ce qu'il comprend d'une part, une mémoire de valeurs d'atténuation (12) adressée par le niveau du signal appliqué à l'entrée de la chaîne de démodulation (7) et couplée par ses sorties de donnée aux entrées de commande de l'atténuateur programmable (12), et d'autre part, un interrupteur (17) interposé en série entre l'atténuateur (5) et la chaîne de démodulation (7) pour isoler la chaîne de démodulation (7) de l'atténuateur (5) lors de la programmation de l'atténuateur par la valeur d'atténuation adressée dans la mémoire (12).

2. Dispositif selon la revendication 1 caractérisé en ce qu'il comprend un convertisseur analogique numérique (11) et un échantillonneur bloqueur (10) reliés en série entre les entrées d'adresse de la mémoire(12) et l'entrée de la chaîne de démodulation (7) pour sélectionner dans la mémoire (12) une valeur d'atténuation fonction du niveau du signal prélevé à l'entrée de la chaîne de démodulation (7) par l'échantillonneur bloqueur (10).

3. Dispositif selon la revendication 2 caractérisé en ce que l'échantillonneur bloqueur (10) est couplé à l'entrée de la chaîne de démodulation (7) par l'intermédiaire d'un détecteur de crête (9) et d'un amplificateur logarithmique (8) reliés en série.

4. Dispositif selon l'une quelconque des revendications 1 à 3 caractérisé en ce qu'il comprend un séquenceur(13)pour commander l'échantillonneur bloqueur (10), le convertisseur analogique numérique (11), la mémoire programmable (12) et l'interrupteur (17).

5. Dispositif selon l'une quelconque des revendications 1 à 4 caractérisé en ce que la mémoire de valeurs d'atténuation (12) est une mémoire morte programmable.

6. Utilisation du dispositif selon l'une quelconque des revendications 1 à 5 à la réalisation de radiogoniomètres multivoies.

## Patentansprüche

1. Vorrichtung zur automatischen Verstärkungssteuerung in einer Hochfrequenz-Emfangskette mit einem Hochfrequenz-Empfangskopf (3), der an eine Demodulationskette (7) über eine programmierbares Dämpfungsglied (5) angeschlossen ist, dadurch gekennzeichnet, daß die Vorrichtung einerseits einen Speicher (12) für Dämpfungswerte, der vom Pegel des am Eingang der Demodulationskette (7) ankommenden Signals adressiert wird und mit seinen Datenausgängen an die Steuereingänge des programmierbaren Dämpfungsglieds (12) gekoppelt ist, und andererseits einen Unterbrecher (17) enthält, der in Reihe zwischen das Dämpfungsglied (5) und die Demodulationskette (7) eingefügt ist, um die Demodulationskette (7) vom Dämpfungsglied (5) während der Programmierung des Dämpfungsglieds mit dem im Speicher (12) adressierten Dämpfungswert zu isolieren.

2. Vorrichtung nach Anspruch 1, dadurch gekennzeichnet, daß sie einen Analog-Digitalwandler (11) und einen Tast-und Haltekreis (10) aufweist, die in Reihe zwischen die Adresseneingänge des Speichers (12) und den Eingang der Demodulationskette (7) eingefügt sind, um im Speicher (12) einen Dämpfungswert abhängig vom Pegel des am Eingang der Demodulationskette (7) durch den Tast-und Haltekreis (10) entnommenen Signals auszuwählen.

3. Vorrichtung nach Anspruch 2, dadurch gekennzeichnet, daß der Tast-und Haltekreis (10) an den Eingang der Demodulationskette (7) über einen Spitzenwertdetektor (9) und einen damit in Reihe geschalteten logarithmischen Verstärker (8) gekoppelt ist.

4. Vorrichtung nach einem beliebigen der Ansprüche 1 bis 3 dadurch gekennzeichnet, daß sie eine Folgeschaltung (13) zur Steuerung des Tast- und Haltekreises (10), des Analog-Digitalwandlers (11), des programmierbaren Speichers (12) und des Unterbrechers (17) aufweist.

5. Vorrichtung nach einem beliebigen der Ansprüche 1 bis 4, dadurch gekennzeichnet, daß der Speicher (12) für die Dämpfungswerte ein programmierbarer Festwertspeicher ist.

6. Verwendung der Vorrichtung nach einem beliebigen der Ansprüche 1 bis 5 bei der Realisierung von Mehrkanal-Funkgoniometern.

## Claims

1. Device for automatically controlling the gain in a radiofrequency reception system, including an HF reception head (3) coupled to a demodulation system (7) through a programmable attenuator (5), characterized in that it comprises, on the one hand, a memory (12) which contains attenuation values (12), is addressed by the level of the signal applied to the input of the demodulation system (7) and is coupled by its data outputs to the control inputs of the programmable attenuator (12), and on the other hand a switch (17) which is interposed in series between the attenuator (5) and the demodulation system (7) in order to isolate the demodulation system (7) from the attenuator (5) when the attenuator is being programmed by the attenuation value addressed in the memory (12).

2. Device according to Claim 1, characterized in that it comprises an analogue-to-digital converter (11) and a sample-and-hold circuit (10) which are connected in series between the address inputs of the memory (12) and the input of the demodulation system (7) in order to select an attenuation value from the memory (12) as a function of the level of the signal sampled at the input of the demodulation system (7) by the sample-and-hold circuit (10).

3. Device according to Claim 2, characterized in that the sample-and-hold circuit (10) is coupled to the input of the demodulation system (7) by means of a peak detector (9) and a logarithmic amplifier (8) which are connected in series.

4. Device according to any one of Claims 1 to 3, characterized in that it comprises a sequencer (13) for controlling the sample-and-hold circuit (10), the analogue-to-digital converter (11), the programmable memory (12) and the switch (17).

5. Device according to any one of Claims 1 to 4, characterized in that the memory (12) containing attenuation values is a programmable read-only memory.

6. Use of the device according to any one of Claims 1 to 5 for the production of multichannel radio-goniometers.
